Europäisches Patentamt

European Patent Office

Office européen des brevets

(19)

(11) **EP 0 554 193 B1**

(12) **FASCICULE DE BREVET EUROPEEN**

(45) Date de publication et mention
de la délivrance du brevet:
**17.07.1996 Bulletin 1996/29**

(51) Int Cl.⁶: **H03F 3/45**, H03F 3/30

(21) Numéro de dépôt: **93420034.6**

(22) Date de dépôt: **25.01.1993**

(54) **Dispositif de compensation de déséquilibre d'un étage d'entrée**

Offsetkompensationsvorrichtung für eine Eingangsstufe

Offset compensation device for an input stage

(84) Etats contractants désignés:
**DE FR GB IT**

(30) Priorité: **31.01.1992 FR 9201312**

(43) Date de publication de la demande:
**04.08.1993 Bulletin 1993/31**

(73) Titulaire: **SGS-THOMSON MICROELECTRONICS
S.A.
F-94250 Gentilly (FR)**

(72) Inventeurs:
• **Kaire, Jean-Claude
  F-38210 Vourey (FR)**

• **Majoux, Bernard
  F-38240 Meylan (FR)**
• **Pontarollo, Serge
  F-38800 Pont de Claix (FR)**

(74) Mandataire: **de Beaumont, Michel
1bis, rue Champollion
38000 Grenoble (FR)**

(56) Documents cités:
**EP-A- 0 115 949        US-A- 5 045 806**

• **PATENT ABSTRACTS OF JAPAN vol. 6, no. 25
(E-94)(903) 13 Février 1982& JP-A-56 144 614**

## Description

La présente invention concerne les amplificateurs opérationnels et en particulier un dispositif de compensation de la tension de décalage d'entrée d'un amplificateur. Le document US-A-5 045 806 divulgue un amplificateur opérationnel comprenant un tel dispositif de compensation.

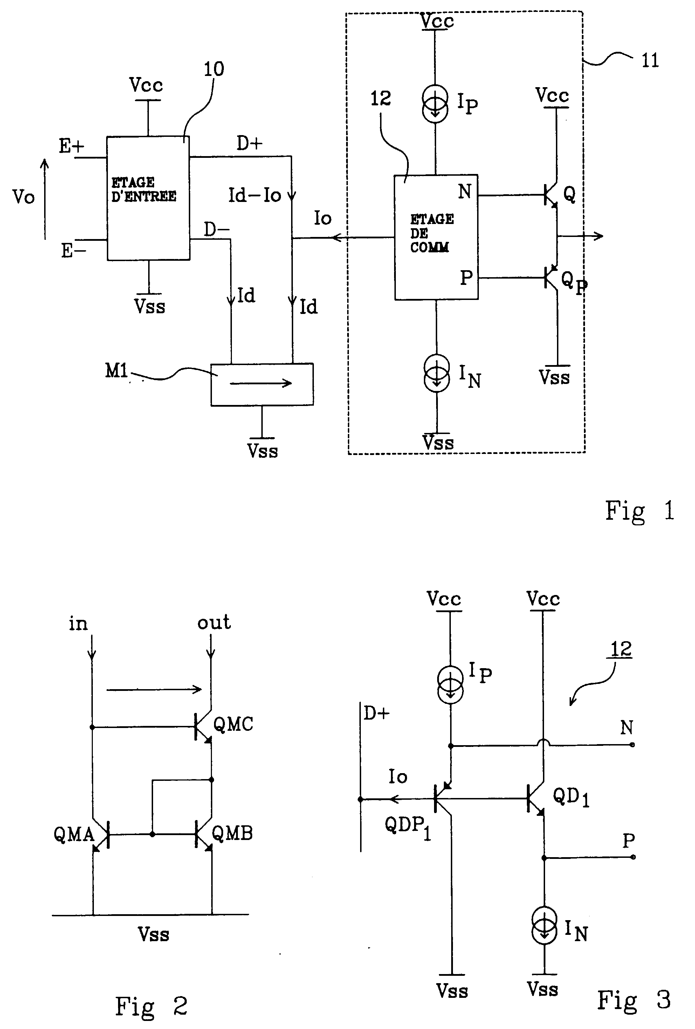

La figure 1 représente très schématiquement une structure d'amplificateur. Cet amplificateur comprend un étage d'entrée différentiel 10 alimenté entre un potentiel haut Vcc et un potentiel bas Vss. Cet étage peut comprendre plusieurs étages de gain élémentaires constitués de transistors montés en amplificateur différentiel. L'étage 10 comprend une sortie différentielle constituée de deux branches D+ et D- qui véhiculent respectivement un courant direct et un courant en opposition de phase proportionnels à la tension présente entre deux bornes d'entrée E+ et E- de l'étage 10. Ces courants dans les branches D+ et Dsont superposés à un courant de repos Id. Les branches D- et D+ sont respectivement reliées à l'entrée et à la sortie d'un miroir de courant M1 dépendant du potentiel bas Vss. La branche D+ est aussi reliée à l'entrée d'un étage de sortie 11 comprenant un étage de commande 12 pilotant par exemple par une sortie N et une sortie P les bases respectives de transistors Q et QP montés selon une configuration dite "push-pull".

La figure 2 illustre un exemple de configuration de miroir de courant dépendant du potentiel bas Vss qui peut être utilisé pour le miroir M1 et pour des miroirs que l'on décrira ultérieurement. Ce miroir comprend deux transistors NPN QMA et QMB à émetteurs reliés au potentiel bas Vss et à bases reliées l'une à l'autre. Le collecteur et la base du transistor QMB sont reliés à l'émetteur d'un transistor QMC dont la base est reliée au collecteur du transistor QMA. L'entrée du miroir de courant correspond au collecteur du transistor QMA et la sortie au collecteur du transistor QMC. Le courant de sortie d'un tel miroir est sensiblement égal au courant d'entrée que multiplie le rapport des surfaces des transistors QMB et QMA.

Dans l'étage de sortie 11 de la figure 1, une source de courant $I_P$ reliée au potentiel haut Vcc et une source de courant $I_N$ reliée au potentiel bas Vss fixent les courants de repos de transistors de l'étage de commande 12. On décrira ultérieurement un exemple de circuit détaillé de l'étage 12 permettant d'obtenir un étage de sortie suiveur.

Avec cette configuration, on fournit à l'entrée de l'étage de commande 12 un courant égal à la différence entre le courant dans la branche D+ et le courant dans la branche D-. Si l'étage 12 est parfait, on a au repos un même courant Id dans les deux branches D+ et D-, le courant consommé par l'étage 12 sur la branche D+ étant nul.

Toutefois, il s'avère que l'étage 12 injecte (ou tire) toujours un courant parasite $I_0$ dans la branche D+. Ce courant parasite provoque un déséquilibre des courants de repos dans les branches D+ et D- qui se traduit par une tension de décalage $V_0$ qu'il faut appliquer entre les bornes E+ et E- pour compenser ce déséquilibre. Cette tension de décalage $V_0$ devient particulièrement importante dans les amplificateurs rapides qui comportent un étage d'entrée 10 à un seul étage de gain. De plus, dans les amplificateurs rapides, l'étage de sortie est à courant de repos élevé et tend par conséquent à injecter un courant parasite élevé dans la branche D+.

Pour remédier à cet inconvénient dans des amplificateurs opérationnels rapides classiques, l'un des courants de repos de l'étage de commande 12, généralement le courant $I_N$, est ajusté après la fabrication de la puce de l'amplificateur opérationnel. Cet ajustage est généralement effectué en changeant la valeur d'une résistance par faisceau laser. Cette opération augmente considérablement le coût de la puce.

La figure 3 illustre de façon détaillée une configuration classique de l'étage de commande 12 permettant d'obtenir un étage de sortie suiveur. L'entrée de l'étage 12 correspond aux bases d'un transistor NPN $QD_1$ et d'un transistor PNP $QDP_1$ montés en collecteur commun. Les sources de courant $I_P$ et $I_N$ sont respectivement reliées aux émetteurs des transistors $QDP_1$ et $QD_1$, et fixent les courants de repos de ces transistors. Les émetteurs des transistors $QDP_1$ et $QD_1$ correspondent respectivement aux sorties N et P de l'étage de commande 12. Avec cette configuration, les transistors $QDP_1$ et $QD_1$ consomment des courants de base valant respectivement $I_P/\beta_P$ et $I_N/\beta_N$, où $\beta_P$ et $\beta_N$ désignent les gains respectifs des transistors $QDP_1$ et $QD_1$. Ainsi, le courant parasite $I_0$ vaut :

$$I_0 = I_P/\beta_P - I_N/\beta_N.$$

En général, sur une même puce, les gains des transistors PNP sont indépendants des gains des transistors NPN et inférieurs à ces derniers. Les valeurs des courants $I_P$ et $I_N$ sont choisis pour annuler le courant parasite $I_0$ pour des valeurs typiques des gains $\beta_P$ et $\beta_N$. Toutefois, dans les nombreux cas où ces gains sont distincts de leurs valeurs typiques, il subsiste un courant parasite $I_0$. Comme on l'a précédemment mentionné, une solution coûteuse consiste à ajuster la valeur de l'un des courants $I_P$ et $I_N$ après fabrication de la puce.

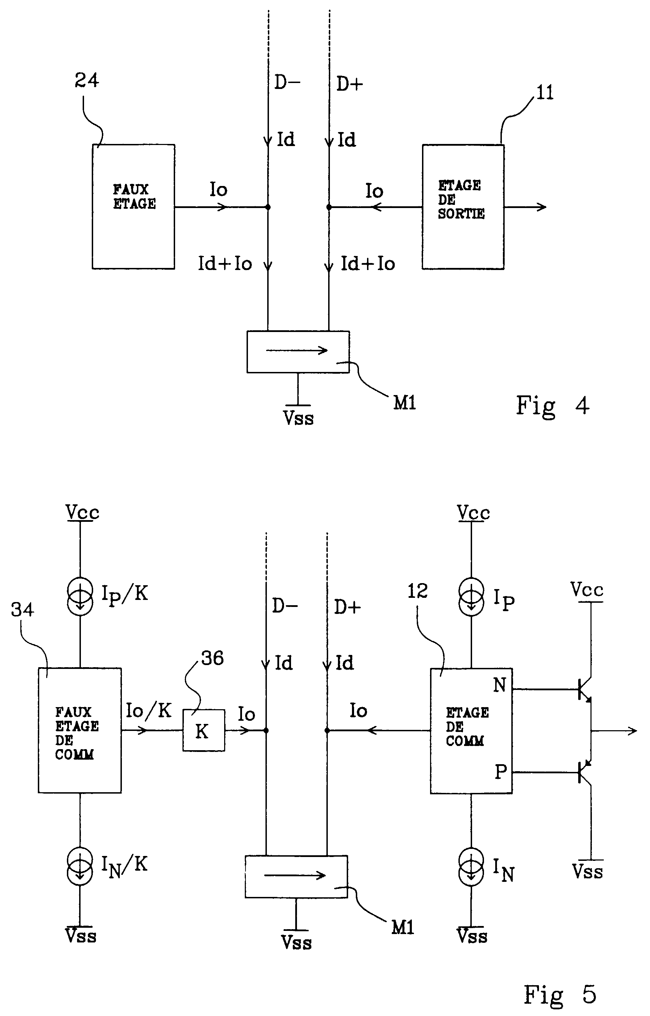

La figure 4 illustre une solution employée dans des amplificateurs opérationnels classiques non rapides (à plus d'un étage de gain). Comme dans la figure 1, des branches D- et D+ de sortie d'un étage d'entrée sont reliées à un miroir de courant M1. Un étage de sortie 11 injecte un courant parasite $I_0$ dans la branche D+. La branche D- est reliée à un faux étage 24 qui présente les mêmes caractéristiques d'entrée que l'étage 11, c'est-à-dire qu'il injecte un courant 10 dans la branche D-.

Avec cette configuration, les branches D- et D+ sont équilibrées et la tension de décalage à l'entrée de l'amplificateur est compensée.

Toutefois, le faux étage 24, pour avoir les mêmes caractéristiques que l'étage 11, doit comprendre des transistors ayant le même courant de repos que les transistors correspondants de l'étage 11. Si l'on utilise ce montage dans un amplificateur. opérationnel rapide, on augmente la consommation de l'amplificateur d'environ 40 % pour un amplificateur consommant déjà un courant élevé (par exemple de l'ordre de 20 mA). Pour cette raison, on ne fabrique pas d'amplificateur opérationnel rapide à faux étage.

Un objet de la présente invention est de réaliser un dispositif de compensation de déséquilibre d'étage d'entrée fiable et de faible coût.

Un autre objet de la présente invention est de réaliser un tel dispositif consommant peu de courant.

Ces objets sont atteints grâce à un dispositif de compensation tel que défini dans les revendications 1 à 5, comprenant un faux étage de sortie à courant de repos K fois inférieur au courant de repos d'un vrai étage de sortie relié à une première branche de sortie d'un étage d'entrée. Le courant dérivé par le faux étage de sortie est multiplié par K dans un multiplieur de courant avant d'être appliqué à une deuxième branche de sortie de l'étage d'entrée.

La présente invention vise plus particulièrement un dispositif de compensation de déséquilibre d'un étage d'entrée à deux branches de sortie de courant dont une première est reliée à l'entrée d'un vrai étage dérivant de cette première branche un courant parasite. Le dispositif comprend un faux étage dérivant un courant de compensation de valeur K (K>1) fois inférieure à la valeur du courant parasite, ce courant de compensation étant amplifié par un amplificateur de gain K avant d'être dérivé de la deuxième branche de sortie de l'étage d'entrée.

Selon un mode de réalisation de la présente invention, le courant de repos du faux étage est K fois inférieur au courant de repos du vrai étage.

Selon un mode de réalisation de la présente invention, les vrai et faux étages comprennent chacun deux transistors de polarité différente dont les courants de repos sont fixés respectivement par deux sources de courant ; les bases des transistors du vrai étage étant reliées directement à ladite première branche de sortie de l'étage d'entrée.

Selon un mode de réalisation de la présente invention, ledit amplificateur comprend, pour chaque transistor du faux étage : un premier miroir de courant dépendant d'un premier potentiel, dont l'entrée est reliée à la base dudit transistor ; et un deuxième miroir de courant dépendant d'un deuxième potentiel, dont l'entrée est reliée à la sortie du premier miroir et dont la sortie est reliée à ladite deuxième branche de sortie de l'étage d'entrée. Au moins un des premier et deuxième miroirs est un miroir multiplieur de sorte que le courant de base dudit transistor soit dérivé de ladite deuxième branche en étant multiplié par K.

Selon un mode de réalisation de la présente invention, les miroirs dépendant du potentiel le plus bas sont multiplieurs par K.

Ces objets, caractéristiques et avantages ainsi que d'autres de la présente invention seront exposés en détail dans la description suivante de modes de réalisation particuliers faite en relation avec les figures jointes parmi lesquelles :

La figure 1, précédemment décrite, représente schématiquement une architecture d'amplificateur opérationnel rapide classique sans dispositif de compensation ;
la figure 2, précédemment décrite, représente une configuration de miroir de courant ;
la figure 3, précédemment décrite, représente une configuration d'étage de commande utilisé dans l'amplificateur de la figure 1 ;
la figure 4, précédemment décrite, représente un dispositif de compensation classique inséré dans l'amplificateur de la figure 1 ;
la figure 5 illustre un dispositif de compensation selon la présente invention inséré dans l'amplificateur de la figure 1 ; et
la figure 6 illustre un mode de réalisation du dispositif de compensation selon l'invention.

Dans les figures, on a représenté des courants par des flèches indiquant un sens ou un signe positif. Des termes tels que "dérivé", "injecté"... pour qualifier un courant n'indiquent pas le signe ou le sens de ce courant.

A la figure 5, on retrouve des mêmes éléments qu'à la figure 1 désignés par des mêmes références. Le dispositif de compensation selon l'invention comprend un faux étage de commande 34 de même configuration que l'étage de commande 12 mais dont le courant de repos est fixé par des sources de courant $I_P/K$ et $I_N/K$ délivrant des courants K fois inférieurs aux courants délivrés par les sources $I_P$ et $I_N$ de l'étage de commande 12. Ainsi, le faux étage 34 dérive un courant de valeur $I_0/K$ ($I_0$ étant la valeur du courant parasite dérivé par l'étage 12). Ce courant $I_0/K$ est multiplié par K par un amplificateur 36 avant d'être dérivé de la branche de sortie D- de l'étage d'entrée.

Ainsi, les courants de repos des deux branches de sortie D- et D+ de l'étage d'entrée sont équilibrés grâce à un faux étage de commande 34 consommant K fois moins de courant qu'un faux étage classique.

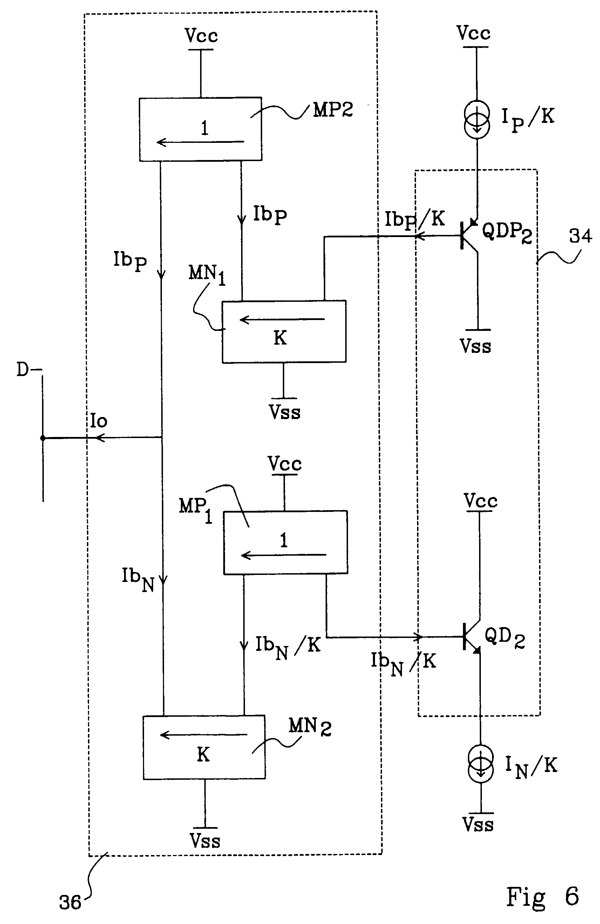

La figure 6 représente un mode de réalisation selon l'invention de l'amplificateur 36 et un mode de réalisation du faux étage de commande 34. Cette configuration est adaptée à un amplificateur opérationnel à étage de commande 12 du type de la figure 3. L'étage 34 comprend un transistor NPN QD2 et un transistor PNP $QDP_2$ correspondant respectivement aux transistors $QD_1$ et $QDP_1$ de l'étage 12 de la figure 3. Les bases de ces transistors $QD_2$ et $QDP_2$, au lieu d'être reliées ensemble comme dans l'étage 12, sont reliées respectivement aux entrées d'un miroir de courant $MP_1$ dépendant du potentiel haut Vcc et d'un miroir de courant $MN_1$ dépendant du potentiel bas Vss. Les sorties des miroirs de courant $MP_1$ et $MN_1$ sont reliées respectivement aux entrées d'un miroir de courant $MN_2$ dépendant du potentiel bas Vss et d'un miroir $MP_2$ dépendant du potentiel haut Vcc. Les sorties des miroirs $MP_2$ et $MN_2$ sont reliées ensemble et constituent la sortie de l'amplificateur 36 reliée à la branche de sortie D- de l'étage d'entrée.

Avec cette configuration, les courants de base des transistors $QD_2$ et $QDP_2$, dont on connaît avec certitude le signe, sont amplifiés séparément et soustraits au niveau de la branche D-.

De préférence, comme cela est indiqué à la figure 6, les miroirs MP dépendant du potentiel haut Vcc sont de gain 1 et les miroirs MN dépendant du potentiel bas Vss sont de gain K. On effectue ce choix car les miroirs dépendant du potentiel bas sont des miroirs à transistors NPN qui sont généralement plus rapides que les transistors PNP et dont les gains β sont généralement plus élevés, ce qui entraîne une meilleure précision du facteur de multiplication K.

La présente invention a été décrite avec un type particulier d'étage de sortie, mais l'homme du métier saura l'adapter à tout autre type.

**Revendications**

1. Dispositif de compensation de déséquilibre d'un étage d'entrée (10) à deux branches de sortie de courant dont une première (D+) est reliée à l'entrée d'un vrai étage (12) de commande dérivant de cette première branche un courant parasite ($I_0$) ; caractérisé en ce qu'il comprend un faux étage de commande (34) délivrant un courant de compensation ($I_0/K$) de valeur K (K>1) fois inférieure à la valeur du courant parasite, ce courant de compensation étant amplifié par un amplificateur de courant (36) de gain K avant d'être dérivé de la deuxième branche de sortie (D-) de l'étage d'entrée.

2. Dispositif de compensation selon la revendication 1, caractérisé en ce que le courant de repos ($I_P/K$, $I_N/K$) du faux étage de commande (34) est K fois inférieur au courant de repos ($I_P$, $I_N$) du vrai étage (12).

3. Dispositif de compensation selon la revendication 2, caractérisé en ce que les vrai (12) et faux (34) étages de commande comprennent chacun deux transistors de polarité différente (QD, QDP) dont les courants de repos sont fixés respectivement par deux sources de courant ; les bases des transistors du vrai étage de commande étant reliées directement à ladite première branche de sortie (D+) de l'étage d'entrée (10).

4. Dispositif de compensation selon la revendication 3, caractérisé en ce que ledit amplificateur (36) comprend, pour chaque transistor du faux étage (34) de commande :

- un premier miroir de courant ($MP_1$, $MN_1$) dépendant d'un premier potentiel, dont l'entrée est reliée à la base dudit transistor ; et
- un deuxième miroir de courant ($MP_2$, $MN_2$) dépendant d'un deuxième potentiel, dont l'entrée est reliée à la sortie du premier miroir et dont la sortie est reliée à ladite deuxième branche de sortie (D-) de l'étage d'entrée (10) ;

au moins un des premier et deuxième miroirs étant un miroir multiplieur de courant de sorte que le courant de base dudit transistor soit dérivé de ladite deuxième branche en étant multiplié par K.

5. Dispositif de compensation selon la revendication 4, caractérisé en ce que les miroirs ($MN_1$, $MN_2$) dépendant du potentiel le plus bas (Vss) sont multiplieurs de courant par K.

**Patentansprüche**

1. Einrichtung zum Kompensieren des Offsets einer Eingangsstufe (10) mit zwei Ausgangszweigen, von denen der erste (D+) mit dem Eingang einer echten Steuerstufe (12) verbunden ist, die von diesem ersten Zweig einen parasitären Strom ($I_0$) ableitet, dadurch gekennzeichnet, daß sie eine Pseudo-Steuerstufe (34) aufweist, die einen Kompensationsstrom ($I_0/K$) mit einem Wert von K (K>1) mal niedriger als der Wert des parasitären Stroms vorsieht, wobei dieser Kompensationsstrom durch einen Stromverstärker (36) verstärkt wird, der eine Verstärkung von K besitzt, und zwar bevor er von dem zweiten Ausgangszweig (D-) der Eingangsstufe gezogen wird.

2. Einrichtung nach Anspruch 1, dadurch gekennzeichnet, daß der Vorspannstrom ($I_P/K$, $I_N/K$) der Pseudo-Steuerstufe (34) K mal niedriger als der Vorspannstrom ($I_P$, $I_N$) der echten Stufe (12) ist.

3. Einrichtung nach Anspruch 2, dadurch gekennzeichnet, daß die echten (12) und Pseudo- (34) Steuerstufen jeweils zwei Transistoren unterschiedlicher Polarität (QD, QDP) aufweisen, deren Vorspannströme jeweils durch zwei Stromquellen vorgesehen werden, wobei die Basen der Transistoren der echten Steuerstufe direkt mit dem ersten Ausgangszweig (D+) der Eingangsstufe (10) verbunden sind.

4. Einrichtung nach Anspruch 3, dadurch gekennzeichnet, daß der Verstärker (36) für jeden Transistor der Pseudo-Steuerstufe (34) folgendes aufweist:

- ein erster Stromspiegel (MP$_1$, MN$_1$) und zwar gekoppelt mit einem ersten Potential, dessen Eingang mit der Basis des Transistors verbunden ist; und
- ein zweiter Stromspiegel (MP$_2$, MN$_2$), und zwar gekoppelt mit einem zweiten Potential, dessen Eingang mit dem Ausgang des ersten Spiegels verbunden ist, und dessen Ausgang mit dem zweiten Ausgangszweig (D) der Eingangsstufe (10) verbunden ist;

wobei mindestens einer der ersten und zweiten Spiegel ein Stromvervielfacherspiegel ist, so daß der Basisstrom des Transistors von dem zweiten Zweig abgeleitet wird, während er um K vervielfacht bzw. mit K multipliziert wird.

5. Einrichtung nach Anspruch 4 dadurch gekennzeichnet, daß die Spiegel (MN$_1$, MN$_2$), die mit dem niedrigeren Potential (Vss) gekoppelt sind, den Strom mit K multiplizieren.

## Claims

1. A device for compensating the offset of an input stage (10) having two current output legs, the first (D+) of which is connected to the input of a real control stage (12) deriving from this first leg a parasitic current (I$_0$); characterized in that it comprises a fake control stage (34) providing a compensation current (I$_0$/K) having a value K times (K>1) lower than the value of the parasitic current, this compensation current being amplified by a current amplifier (36) having a gain equal to K, before being drawn from the second output leg (D-) of the input stage.

2. A device as claimed in claim 1, characterized in that the bias current (I$_P$/K, I$_N$/K) of the control fake stage (34) is K times lower than the bias current (I$_P$, I$_N$) of the real stage (12).

3. A device as claimed in claim 2, characterized in that the real (12) and fake (34) control stages each comprise two transistors of different polarity (QD, QDP), the bias currents of which are respectively established by two current sources; the bases of the transistors of the real control stage being directly connected to said first output leg (D+) of the input stage (10).

4. A device as claimed in claim 3, characterized in that said amplifier (36) comprises, for each transistor of the fake control stage (34):

- a first current mirror (MP$_1$, MN$_1$) coupled to a first potential, the input of which is connected to the base of said transistor; and
- a second current mirror (MP$_2$, MN$_2$) coupled to a second potential, the input of which is connected to the output of the first mirror, and the output of which is connected to said second output leg (D-) of the input stage (10);

at least one of the first and second mirrors being a current multiplier mirror so that the base current of said transistor is derived from said second leg while being multiplied by K.

5. A device as claimed in claim 4, characterized in that the mirrors (MN$_1$, MN$_2$) coupled to the lower potential (Vss) multiply the current by K.

Fig 1

Fig 2

Fig 3

Fig 4

Fig 5

Fig 6